# EUROPEAN PATENT SPECIFICATION

(11) **EP 0 536 726 B1**
(45) Date of publication and mention of the grant of the patent: **21.04.1999**
(21) Application number: 92117130.2
(22) Date of filing: 07.10.1992
(51) Int. Cl.: H04B 10/00, G02B 6/42, G02B 5/32

(54) **Arrangement of optically interconnecting a plurality of light emitter/receiver modules respectively mounted on separate circuit boards**
Anordnung zum optischen Verbinden einer Vielzahl von Lichtsende-/-empfänger-Moduln, die auf jeweils getrennten Leiterplatten angeordnet sind
Arrangement d'interconnexions optiques pour plusieurs modules émetteur/récepteur montés sur des circuits imprimés séparés

(30) Priority: 07.10.1991 JP 258996/91
(43) Date of publication of application: 14.04.1993
(73) Proprietor: NEC CORPORATION, Tokyo (JP)
(72) Inventor: Yamanaka, Yutaka, Minato-ku, Tokyo (JP)
(74) Representative: VOSSIUS & PARTNER

(56) References cited:
- US-A- 4 358 858
- US-A- 4 823 403
- OPTICS LETTERS., vol.16, no.16, August 1991, WASHINGTON US pages 1222 - 1224 HAMANAKA K.
- Central Patents Index, Basic Abstracts Journal, Section T, week 9041 * Abstract 90-312504/41 * &US-Published-Patent-Application-7471316 (Corda) & US-A-5 134 508 [A.J.Corda] (Corresponds to NTIS publication of US-Published Patent-Application 7471316)
- PATENT ABSTRACTS OF JAPAN vol. 13, no. 116 (P-845) 22 March 1989 & JP-A-63 291 014 (FUJIKURA LTD) 28 November 1988
- IBM TECHNICAL DISCLOSURE BULLETIN., vol.32, no.3A, 1989, NEW YORK US pages 98 - 103 'Optical wiring using holographic beam deflection'

## Description

The present invention relates to optical interconnection which is well suited for parallel processing in a digital computer system, and more specifically to an arrangement of optically interconnecting a plurality of light emitter/receiver devices which are respectively mounted on a plurality of circuit boards.

Many recent advances in a computer architecture are based on the concept of parallel processing. Parallel processing in a computer can be defined as the concurrent execution of instructions.

Parallel processing itself is well known in the art and is not important for an understanding of the present invention and thus will not be described in detail.

In order to implement the parallel processing in a computer system, it is important to electrically couple all the processors in a computer system with one another. However, it is extremely difficult or practically, impossible to couple all the processors due to limited space in the system (for example) in the event that the number of processors increases.

An approach to solving such a problem encountered in electrically conductive wire interconnection between the processors, is to make use of optical interconnection.

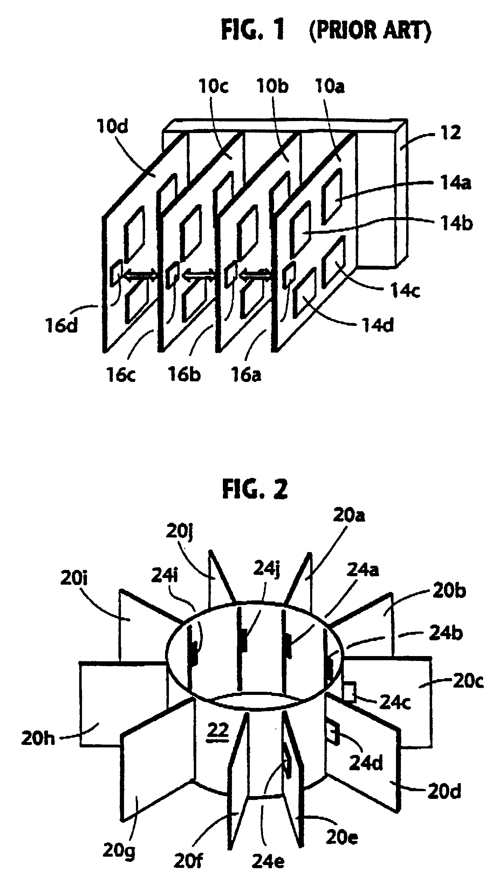

Before turning to the present invention it is deemed preferable to briefly discuss, with reference to Fig. 1, a known technique for optically interconnecting two light beam emitter/receiver modules mounted on adjacent circuit boards.

As shown in Fig. 1, a plurality of circuit boards 10a-10d each of a plug-in type (for example) are inserted into a backplane 12. The boards 10a-10d respectively carry thereon a plurality of electrical logic elements 14a-14d (only the elements on the board 10a are denoted) which are, for example, a CPU (Central Processing Unit), memories (RAM and/or ROM), etc. Further, each board is provided with a light beam emitter/receiver module 16a-16d. The modules 16a-16d are able to exchange optical data between the adjacent one(s) via light beams denoted by arrows. Thus, the electrical wire coupling between the adjacent boards can be eliminated.

Similar arrangements are known from US-A-4 358 858, US-A-5,134,508, US-Application (published)-7471316, US-A-4 813 403, and IBM-TDB vol. 32, No 3A, 1989, pages 98-103.

However, the above mentioned prior art arrangement is insufficient in terms of reduction of electrical interconnection in that only the adjacent boards are optically coupled.

It is an object of the present invention to provide an arrangement wherein all of the circuit boards can be optically interconnected. This object is solved with the features of the claims.

The arrangement as described is for optically interconnecting a plurality of light emitter/receiver modules with one another. The plurality of light emitter/receiver modules are respectively mounted on a plurality of circuit boards at edge portions thereof. A board supporter is provided to support the plurality of circuit boards in a manner wherein the plurality of light beam emitter/receiver modules are in line-of-sight relationships with one another. The board supporter is a cylindrical member or a polygon tube-like member.

More specifically an aspect of the present invention comes in an arrangement of optically interconnecting a plurality of light beam emitter/receiver modules respectively mounted on a plurality of circuit boards at edge portions thereof, comprising: a board supporter for supporting said plurality of circuit boards in a manner wherein said plurality of light beam emitter/receiver modules are in line-of-sight relationships with one another.

The features and advantages of the present invention will beccme more clearly appreciated from the following description taken in conjunction with the accompanying drawings in which like elements are denoted by like reference numerals and in which:
Fig. 1 is a perspective view schematically showing a known arrangement wherein the adjacent circuit boards are optically interconnected, this figure having been referred to in the opening paragraphs of the instant disclosure;
Fig. 2 is a sketch schematically showing a first embodiment of the present invention;
Fig. 3 is an illustration of a circuit board used in the embodiments of the present invention;
Figs. 4-6 each is an enlarged illustration of one block of Fig. 3:
Fig. 7 is a light beam receiver (detector) with a converging lens;
Fig. 8 is a sketch schematically showing a second embodiment of the present invention;

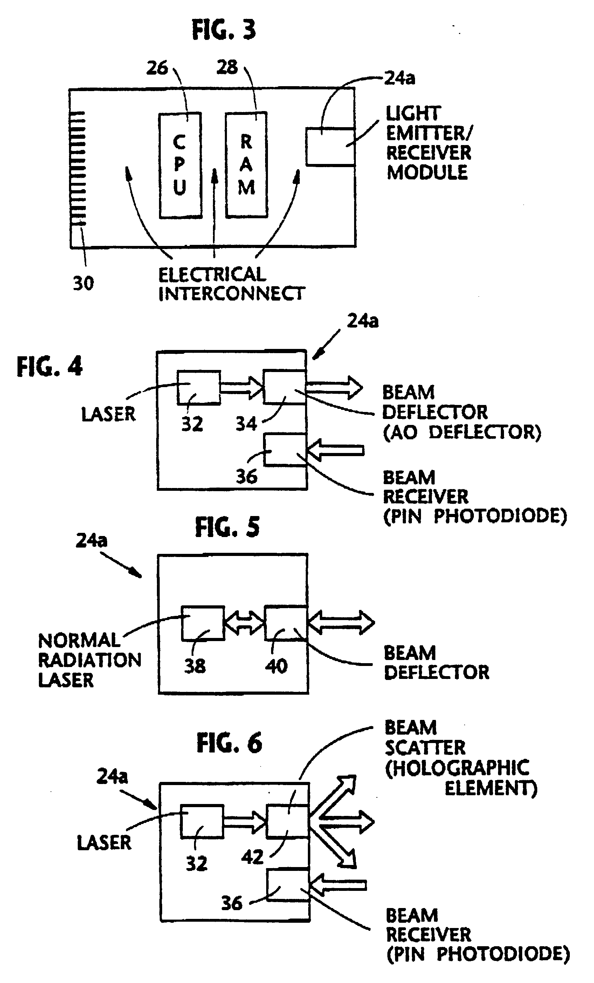

Fig. 5 is a sketch schematically showing a third embodiment of the present invention; and

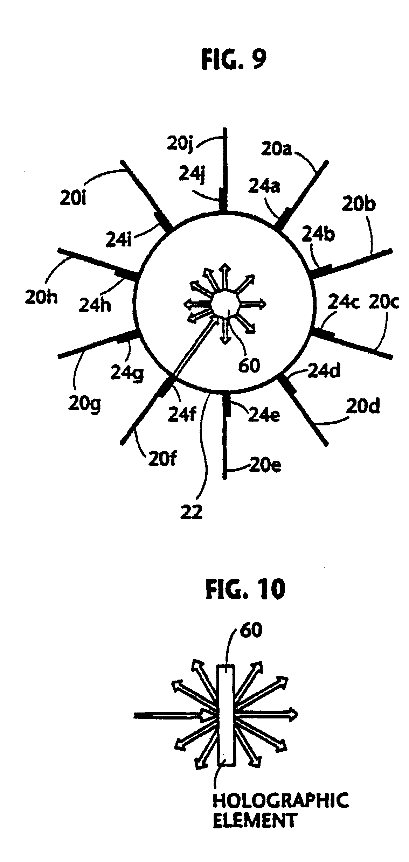

Fig. 10 is an illustration of a holographic element which is used in the third embodiment.

A first embodiment of the present invention will be discussed with reference to Figs. 2-7.

As shown in Fig. 2, a plurality of circuit boards 20a-20j are fixedly attached to or supported by a board supporter 22 using suitable holding means (not shown). The supporter 22 takes the form of tube-like member. Each of the boards 20a-20j is arranged in a manner that the main surface thereof is parallel with an imaginary plane extending radially from the longitudinal axis of the supporter 22. The circuit boards 20a-20j respectively carry thereon light beam emitter/receiver modules 24a-24j although all of them are not shown in Fig. 2. In more specific terms, each of the light beam emitter/receiver modules 24a-24j is provided at the edge portion which is held by the supporter 22.

Fig. 3 is a schematic plan view of the circuit board 20a which includes, in addition to the aforesaid module 24a, a plurality of electrical elements such as a CPU 26, a RAM 28, an edge connector 30, etc. The electrical interconnection on the board 24a is omitted merely for the sake of brevity. Each of the other circuit boards 20b-20j is essentially identical with the board 20a of Fig. 3 and hence is not shown in the drawings attached.

The circuit boards 24a-24j each is electrically coupled to an external logic assembly (not shown) via the corresponding edge connector.

Returning to Fig. 2, the board supporter 22 is provided to rigidly support the circuit boards 20a-20j in a manner that the light beam emitter/receiver modules 24a-24j are in line-of-sight relationships with one another. That is to say, there is no obstacle on the straight line between any two of the modules 24a-24j. This implies that any electrical interconnection between the boards 20a-20j can effectively be eliminated.

Figs. 4-6 each illustrates in detail the light emitter/receiver module 24a (for example). It should be noted that each of the other modules 24b-24j can be configured in exactly the same as shown in Figs. 4-6.

The Fig. 4 arrangement includes a light beam emitter (e.g., semiconductor laser) 32, a beam deflector 34 (e.g., acoustooptic (AO) deflector) and a beam receiver (detector) such as a PIN photodiode 36. Rays of light emitted from the AO deflector 34 can be directed to an arbitrary direction as is known in the art. The light beam emitter/receiver module of Fig. 4 is suited for interconnection between two modules (viz., one-to-one optical interconnection).

Fig. 5 illustrates another example of the light beam emitter/receiver module 24a which includes a normal radiation type laser 38 and a beam deflector 40. As is known, the normal radiation laser 38 exhibits two functions: emission and reception of light beams. The module 24a is also suitable for one-to-one optical interconnection between two light beam emitter/receiver modules.

Fig. 6 shows still another example of the light beam emitter/receiver module 24a which differs from the module shown in Fig. 4 in that the beam deflector 34 of Fig. 4 is replaced with a beam scatter such as a holographic element 42. This type of module is utilized for one-to-multiple optical interconnection between the modules 24a-24j.

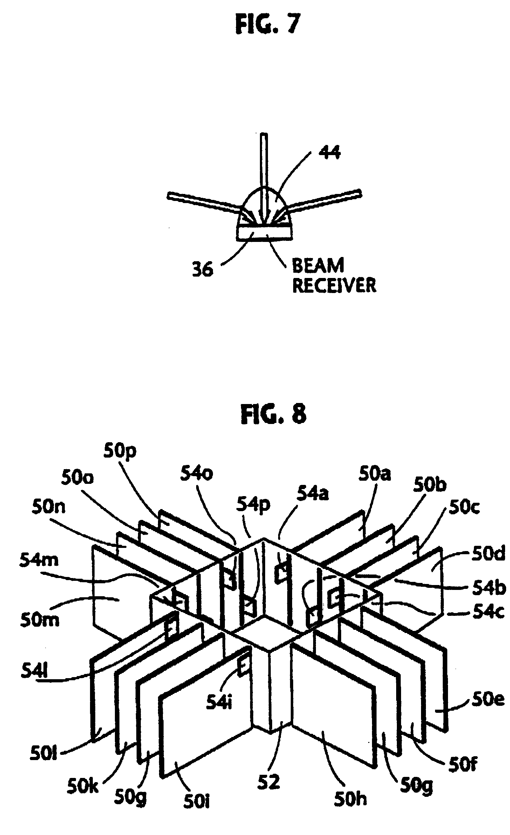

The beam receiver 36 (Figs. 4 and 6) may be covered by a converging lens 44 (Fig 7) via which the rays of light incident on the receiver 36 can effectively be collected.

A second embodiment of the present invention will be described with reference to Fig. 8.

In Fig. 8, a plurality of circuit boards 50a-50p are attached to a board supporter 52 which takes the form of a rectangular tube-like member in this particular embodiment. The boards 50a-50p are respectively provided with light beam emitter/receiver modules 54a-54p as in the first embodiment. However, in order to ensure that the modules 54a-54p are arranged in line-of-sight relationships with one another, the modules 54a-54p each protrudes from the corresponding edge of the board. Further, the adjacent modules 54a-54p are provided at different positions on the edges of the boards.

A third embodiment of the present invention will be discussed with reference to Figs. 9-10. The third embodiment is additionally provided with a light beam scatter 60 as compared with the first embodiment. By way of example, the beam scatter 60 takes the form of a polygon pillar (post) made of glass (Fig. 9) or a holographic element shown in Fig. 10. In the third embodiment, light beams emitted from one of the light emitter/receiver modules 24a-24j impinge on the beam scatter 60 and propagates in different directions as shown and thus establishes the one-to-multiple optical interconnection between the modules 24a-24j.

The concept of the third embodiment is applicable to the case wherein the board support is a polygon tube-like member as in the second embodiment.

## Claims

1. An arrangement of optically interconnecting a plurality of light beam emitter/receiver modules (24a-24j) respectively mounted on a plurality of circuit boards (20a-20j) at edge portions thereof, characterized by:
a tube-like member (22) which carries said plurality of circuit boards in parallel along with its longitudinal axis,
wherein the light beam emitter/receiver modules respectively point through openings provided in the tube-like member towards its longitudinal axis, and
wherein each of the light beam emitter/receiver modules is in line-of-signal contact with at least one of the remaining light beam emitter/receiver modules.

2. An arrangement as claimed in claim 1, wherein said tube-like member is of cylindrical shape.

3. An arrangement as claimed in claim 1, wherein said tube-like member has a circular or polygon cross-section.

4. An arrangement as claimed in any of claims 1 to 3, wherein each of said light beam emitter/receiver modules includes a light beam emitter and a light beam scatter, said light beam scatter dispersing light beams emitted from said light emitter.

## Patentansprüche

1. Anordnung zum optischen Verbinden mehrerer Lichtstrahl-Sender/Empfänger-Module (24a-24j), die jeweils auf mehreren Leiterplatten (20a-20j) an deren Kantenabschnitten angeordnet sind, gekennzeichnet durch:
ein röhrenähnliches Teil (22), das die mehreren Leiterplatten parallel entlang seiner Längsachse trägt,
wobei die Lichtstrahl-Sender/Empfänger-Module jeweils durch in dem röhrenähnlichen Teil vorgesehene Öffnungen auf dessen Längsachse zeigen, und
wobei jedes der Lichtstrahl-Sender/Empfänger-Module in Signallinienkontakt mit mindestens einem der übrigen Lichtstrahl-Sender/Empfänger-Module ist.

2. Anordnung nach Anspruch 1, wobei das röhrenähnliche Teil eine zylindrische Form hat.

3. Anordnung nach Anspruch 1, wobei das röhrenähnliche Teil einen kreisförmigen oder vieleckigen Querschnitt hat.

4. Anordnung nach einem der Ansprüche 1 bis 3, wobei jedes der Lichtstrahl-Sender/Empfänger-Module einen Lichtstrahlsender und eine Lichtstrahlstreuvorrichtung aufweist, wobei die Lichtstrahlstreuvorrichtung von dem Lichtsender gesendete Lichtstrahlen zerstreut.

## Revendications

1. Arrangement d'interconnexions optiques d'une pluralité de modules émetteurs/récepteurs de pinceaux lumineux (24a-24j) respectivement montés sur une pluralité de cartes à circuits imprimés (20a-20j) à des parties marginales de celles-ci, caractérisé par :
- un organe tubulaire (22) qui supporte ladite pluralité de cartes à circuits imprimés en parallèle suivant son axe longitudinal,
- dans lequel les modules émetteurs/récepteurs de pinceaux lumineux visent respectivement des ouvertures fournies dans l'organe tubulaire vers son axe longitudinal, et
- dans lequel chacun des modules émetteurs/récepteurs de pinceaux lumineux est en contact de ligne de signal avec au moins un des modules émetteurs/récepteurs de pinceaux lumineux restants.

2. Arrangement selon la revendication 1, dans lequel ledit organe tubulaire est de forme cylindrique.

3. Arrangement selon la revendication 1, dans lequel ledit organe tubulaire a une section transversale circulaire ou polygonale.

4. Arrangement selon l'une quelconque des revendications 1 à 3, dans lequel chacun desdits modules émetteurs/récepteurs de pinceaux lumineux comporte un émetteur de pinceaux lumineux et un disperseur de pinceaux lumineux, ledit disperseur de pinceaux lumineux dispersant des pinceaux lumineux émis depuis ledit émetteur de pinceaux lumineux.
